# EUROPEAN PATENT SPECIFICATION

(11) **EP 3 692 575 B1**
(45) Date of publication and mention of the grant of the patent: **12.02.2025**
(21) Application number: 18778594.4
(22) Date of filing: 21.08.2018
(51) Int. Cl.: H01L 23/522, H01L 27/088, H01L 27/06, H01L 27/092, H01L 29/78

(54) **MIDDLE-OF-LINE SHIELDED GATE FOR INTEGRATED CIRCUITS**
ABGESCHIRMTES MIDDLE-OF-LINE-GATTER FÜR INTEGRIERTE SCHALTUNGEN
GRILLE PROTÉGÉE DE MILIEU DE LIGNE POUR CIRCUITS INTÉGRÉS

(30) Priority: 03.10.2017 US 201715723224
(43) Date of publication of application: 12.08.2020
(73) Proprietor: QUALCOMM Incorporated, San Diego, CA 92121-1714 (US)
(72) Inventor: GE, Lixin, San Diego California 92121 (US); YANG, Bin, San Diego California 92121 (US); LU, Ye, San Diego California 92121 (US); BAO, Junjing, San Diego California 92121 (US); CHIDAMBARAM, Periannan, San Diego California 92121 (US)
(74) Representative: Tomkins & Co
(86) International application number: PCT/US2018/047173
(87) International publication number: WO 2019/070346

(56) References cited:
- JP-A- 2011 138 972
- US-A1- 2005 017 298
- US-A1- 2013 234 292
- US-A1- 2016 172 456
- US-A1- 2016 351 500
- US-B1- 9 633 996

## Description

### Field of the Disclosure

This invention relates generally to field-effect transistors (FETs), and more particularly to reducing gate to drain capacitance in metal-oxide semiconductor field-effect transistors (MOSFETs) for integrated circuits (ICs).

### Background

Metal-oxide semiconductor field-effect transistors (MOSFETs) are valuable components in many high input impedance or high gain circuits, high speed switching circuits, or radio frequency (RF) integrated circuits (ICs) that are used, for example, in set top boxes, entertainment units, navigation devices, communications devices, fixed location data units, mobile location data units, mobile phones, cellular phones, smart phones, tablets, phablets, computers, portable computers, desktop computers, personal digital assistants (PDAs), monitors, computer monitors, televisions, tuners, radios, satellite radios, music players, digital music players, portable music players, digital video players, video players, digital video disc (DVD) players, portable digital video players, and automobiles. The benefit of power MOSFETs include generally high switching speeds and a relatively low on-resistance.

Prior art document US 2013/0234292 A1 discloses a thin film resistor structure formed on a metal gate structure.

Prior art document US 9 633 996 B1 discloses a high density area efficient thin-oxide decoupling capacitor using conductive gate resistor.

Prior art document US 2016/0172456 A1 discloses a high resistance metal etch-stop layer positioned above the metal gate of a transistor.

Prior art document US 2005/0017298 A1 discloses a shielding structure for use in a metal-oxide-semiconductor device.

Shielded gate MOSFETs are preferred because they provide reduced gate-to-drain capacitance, reduced on-resistance, and increased breakdown voltage of the transistor. By shielding the gate from the electric field in the drift region, the shielded gate MOSFET structure substantially reduces the gate-to-drain capacitance. The shielded gate MOSFET structure also provides the added benefit of higher minority carrier concentration in the drift region for the device's breakdown voltage and hence lower on-resistance.

A conventional way of shielding a gate MOSFET is to fabricate a Tungsten Silicide (WSi) Faraday shield between the gate and the underlying drain. Fabrication of the WSi Faraday shield, however, requires an additional polysilicon deposition, mask, and etch. These additional steps add costs, require additional specification, and may add defects to the IC. As such, there is a need for an apparatus and process for fabricating a shielded gate MOSFET in an IC that reduces costs and steps in process flow, and that still provides effective reduction of gate to drain parasitic capacitance.

### SUMMARY OF THE DISCLOSURE

A middle of line, MOL, shielded gate for an integrated circuit, IC, is disclosed as recited in claim 1. A method of fabricating a shielded gate in a semiconductor die for an integrated circuit, IC, is disclosed as recited in claim 11. Further embodiments are disclosed in the dependent claims.

Aspects disclosed herein include middle-of-line (MOL) shield gates in integrated circuits (ICs). In this regard, in certain aspects disclosed herein, one or more metal resistors are fabricated in a MOL layer of an IC to shield the IC. The MOL layer is formed above and adjacent to an active semiconductor area in a front-end-of-line (FEOL) portion of the IC that includes devices, e.g., MOSFETS. The metal resistor(s) can be coupled through contacts formed in the MOL layer to interconnect lines in interconnect layer(s) so as to be coupled, for example, to a voltage source, on-chip RF, and/or power circuit in the IC.

Thus, by fabricating a metal resistor in the MOL layer in the IC, the metal resistor can advantageously be localized very close to semiconductor devices, such as transistors, to more accurately shield the semiconductor devices. Also, by providing the metal resistor in the MOL layer, the same fabrication processes used to create contacts in the MOL layer can also be used to fabricate the metal resistor in the MOL layer. Further, because the MOL layer is already provided in the IC to provide contacts between the semiconductor devices in the active semiconductor layer and the interconnect layers, additional area may not be required to provide the metal resistors in the IC.

### BRIEF DESCRIPTION OF THE FIGURES

Figure 1 is a diagram illustrating a cross-sectional, side view of an integrated circuit (IC) that includes a middle-of-line (MOL) shield gate comprising a metal resistor;
Figure 2 is a flowchart illustrating an exemplary process of fabricating a MOL shielded gate, such as the MOL shielded gate in the IC in Figure 1;
Figures 3A-3F are exemplary process stages of fabricating a MOL shielded gate in an IC, such as the MOL shielded gate in the IC in Figure 1;
Figure 4 is a generalized representation of an exemplary system including a MOL shield gate; and
Figure 5 is a block diagram of an exemplary wireless communications device that includes radio-frequency (RF) components and MOL shield gate.

### DETAILED DESCRIPTION

With reference to the drawing figures, several exemplary aspects of the present disclosure are described. The word "exemplary" is used herein to mean "serving as an example, instance, or illustration." Any aspect described herein as "exemplary" is not necessarily to be construed as preferred or advantageous over other aspects.

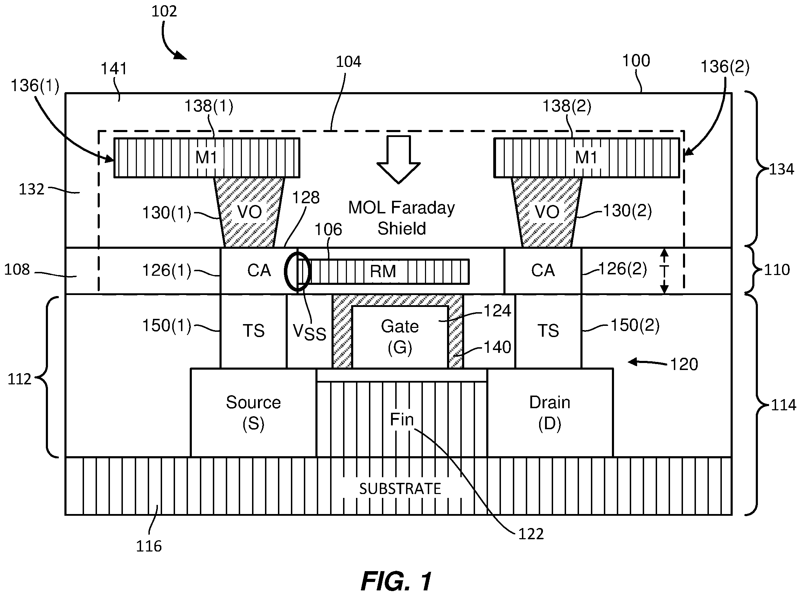

Figure 1 is a diagram illustrating a cross-sectional, side view of a semiconductor die 100 for an IC 102 that includes a MOL shielded gate 104. MOL shielded gate 104 is provided on-chip in IC 102 in this example. MOL shielded gate 104 includes a metal resistor 106 that is fabricated from a metal material provided in a MOL layer 108 of a MOL area 110 of semiconductor die 100. It should be noted that metal resistor 106 is present in current fabrication process and, as such, there is no additional etching, mask layering, or costs associated with fabricating metal resistor 106. Metal resistor 106 is fabricated at MOL area 110 providing a shielded gate and effective reduction of gate to drain parasitic capacitance as further explained below. Metal resistor 106 has a resistance based on a material and sizing of metal resistor 106. MOL layer 108 is formed above and adjacent to one or more active semiconductor layers 112 in a front-end-of-line (FEOL) area 114 of semiconductor die 100 disposed on a substrate 116. Active semiconductor layers 112 include semiconductor devices, such as a MOSFET for example. In this example, the MOSFET is a FinFET 120 including a Fin 122 providing a conductive channel with a gate material 124 disposed above and/or adjacent to Fin 122.

Because metal resistor 106 is disposed in MOL layer 108 immediately above and/or adjacent to active semiconductor layers 112 in this example, metal resistor 106 in MOL layer 108 can advantageously be localized very close to semiconductor devices in active semiconductor layers 112, such as FinFET 120, to more effectively reduce gate to drain parasitic capacitance.

To provide connectivity to MOL shielded gate 104 and direct voltage Vss to metal resistor 106, a first contact 126(1) is provided in MOL layer 108. First contact 126(1) is electrically coupled to a contact area 128 of metal resistor 106. For example, first contact 126(1) may be conductive contact pad made out of a Tungsten (W) material. In this example, first contact 126(1) physically contacts contact area 128. First and second vertical interconnect accesses ViasO (VOs) 130(1), 130(2) are fabricated in an interconnect layer 132 in an interconnect area 134 of semiconductor die 100 in aligned contact with first and second contacts 126(1), 126(2). For example, interconnect layer 132 is shown as a metal 1 (M1) layer directly above MOL layer 108. First and second interconnects 136(1), 136(2) are formed in interconnect layer 132 above and in contact with first and second VOs 130(1), 130(2). For example, first and second interconnects 136(1), 136(2) may be metal lines 138(1), 138(2) that were fabricated from a conductive material disposed in trenches formed in a dielectric material 141. In this manner, connectivity to MOL shielded gate 104 is provided through metal lines 138(1), 138(2) in this example.

Thus, by fabricating metal resistor 106 in MOL layer 108 in IC 102, metal resistor 106 can advantageously be localized and very close to semiconductor devices in active semiconductor layers 112, to effectively reduce gate to drain parasitic capacitance. The MOL layer 108 has a thickness T of approximately eighteen (18) nanometers (nm) or less, which is a thickness ratio of approximately 0.26 or less to the thickness of semiconductor layers 112. Further, because MOL layer 108 is already provided in IC 102 to provide contacts between semiconductor devices in the semiconductor layers 112 and interconnect layer 132 including, e.g., first and second semiconductor layer contacts 150(1), 150(2), additional area may not be required to provide metal resistor 106 in IC 102. For example, metal resistor 106 may have approximately a width/length (W/L) of 0.21 µm / 0.21 µm.

Metal resistor 106 can be formed from any conductive material. As examples, metal resistor 106 can be formed from Tungsten Silicide (WSi), Titanium Nitride (TiN), and Tungsten (W). Metal resistor 106 should have a sufficient resistance to be sensitive to changes in ambient temperature. For example, the resistance of metal resistor 106 may be at least 400 ohms per W/L µm of semiconductor devices. Also, by disposing metal resistor 106 in MOL layer 108, it may be efficient from a fabrication process standpoint to form metal resistor 106 from the same material as a work function material 140 disposed adjacent to gate (G) 124 of FinFET 120.

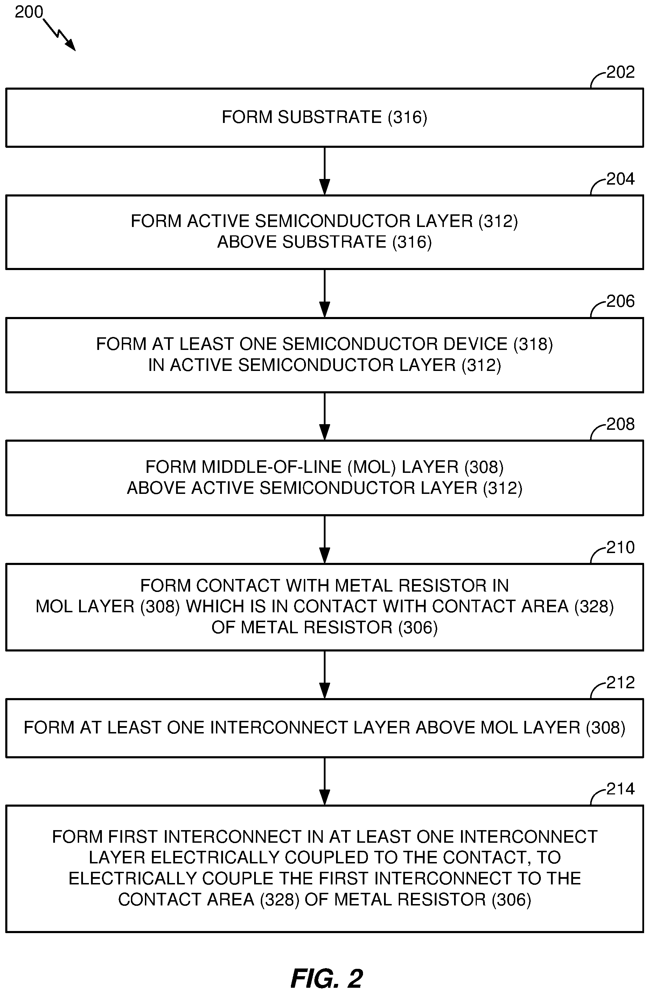

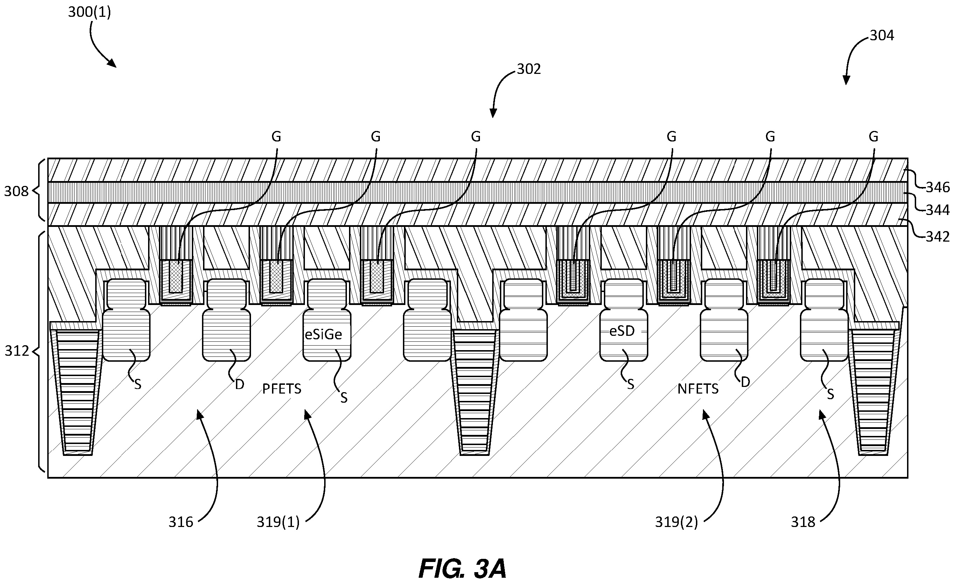

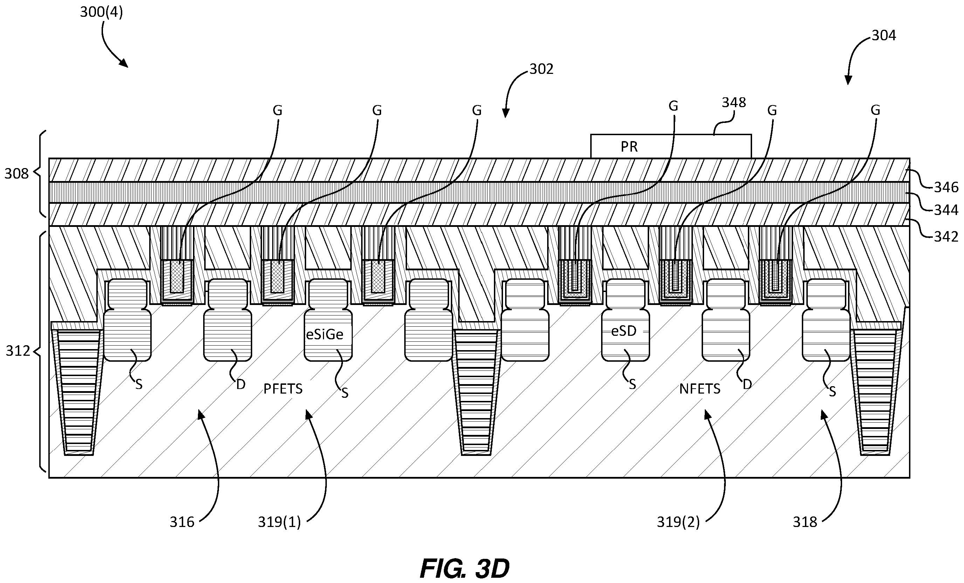

Figure 2 is a flowchart illustrating an exemplary process 200 of fabricating a MOL shielded gate in an IC, such as MOL shielded gate 104 in IC 102 in Figure 1. Figures 3A-3F are exemplary process stages 300(1)-300(6) of fabricating a MOL metal resistor shielded gate in an IC, such as MOL shielded gate 104 comprising metal resistor 106 in IC 102 in Figure 1. The exemplary process 200 in Figure 2 and the exemplary process stages 300(1)-300(6) to fabricate a MOL 304 in Figures 3A-3F will now be described.

As illustrated in processing stage 300(1) in Figure 3A, a first step of fabricating a MOL shielded gate 304 in an IC 302 is to form a substrate 316 (block 202 in Figure 2). An active semiconductor layer 312 is formed above substrate 316 as shown in Figure 3A (block 204 in Figure 2). Further, as shown in Figure 3A, at least one semiconductor device 318 is formed in active semiconductor layer 312 (block 206 in Figure 2). In this example, PFETs 319(1) and a NFETs 319(2) are formed in active semiconductor layer 312. As shown, sources (S), drains (D), and gates (G) are formed for PFETs 319(1) and NFETs 319(2).

Next, a MOL layer 308 is formed above active semiconductor layer 312 (block 208 in Figure 2). In this example, middle MOL layer 308 is comprised of a first insulating layer 342 followed by a metal material layer 344, with another second insulating layer 346 disposed on metal material layer 344. First and second insulating layers 342 and 346 in this example are oxide layers. Metal material layer 344 may be formed of any conductive material that will provide a desired resistance, such as tungsten. As previously discussed, metal material layer 344 may be formed from the same work function material used to create one or more gates (G) in active semiconductor layer 312. First insulating layer 342 is configured to insulate the MOL layer 308 from the active semiconductor layer 312 and semiconductor devices fabricated in the active semiconductor layer 312. Metal material layer 344 will be processed to form a metal resistor as will be discussed in more detail below.

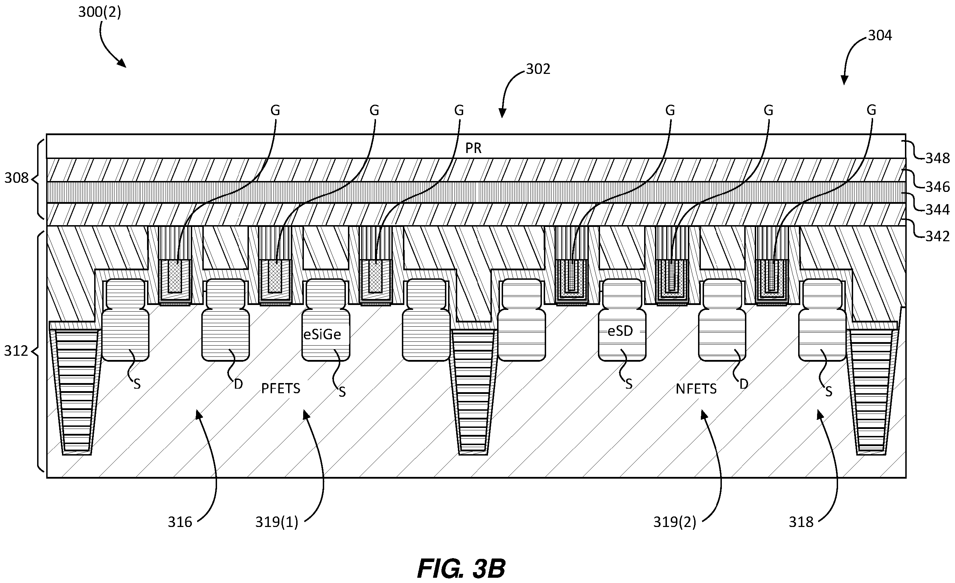

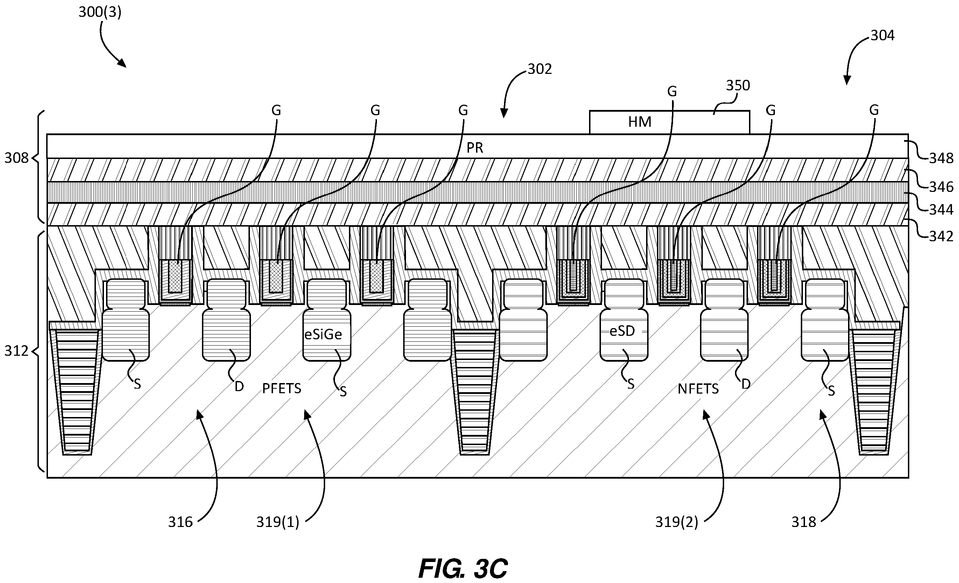

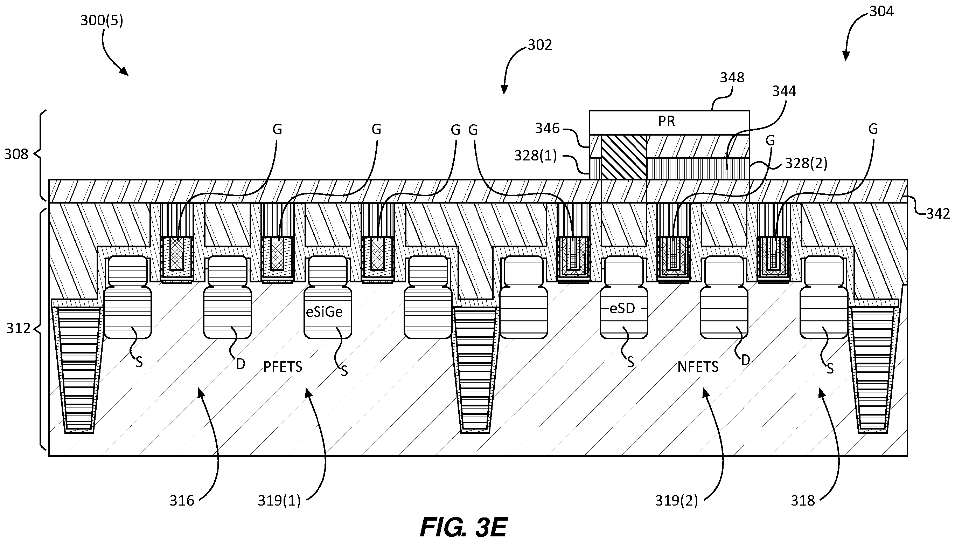

Next, as shown in a second process stage 300(2) in Figure 3B, to prepare the metal resistor to be formed in MOL layer 308, a photoresist layer 348 is disposed on top of MOL layer 308, and more particularly second insulating layer 346. Next, as shown in a third process stage 300(3) in Figure 3C, a hard mask 350 is disposed on photoresist layer 348 to prepare for the formation of metal resistor from metal material layer 344. Hard mask 350 is sized based on a desired size of the metal resistor. Hard mask 350 may be placed so that the metal resistor is formed from metal material layer 344 above and/or adjacent to a semiconductor device in active semiconductor layer 312 to effectively reduce gate to drain parasitic capacitance. The IC 302 is then processed by exposure to light. As shown in the process stage 300(5) in Figure 3E, photoresist layer 348, second insulating layer 346, and metal material layer 344 are removed except under the area where hard mask 350 was disposed in process stage 300(3) in Figure 3C. After the exposure of photoresist layer 348, second insulating layer 346 and metal material layer 344 that are not underneath hard mask 350 are removed. The remaining metal material layer 344 forming a metal resistor 306 that has a contact area 328(1) and 328(2) for providing electrical contact to metal resistor as part of MOL shielded gate 304. For example, second insulating layer 346 may be removed by a chemical etch process or other removal process. Metal material layer 344 may be removed by a different chemical etch process or other removal process.

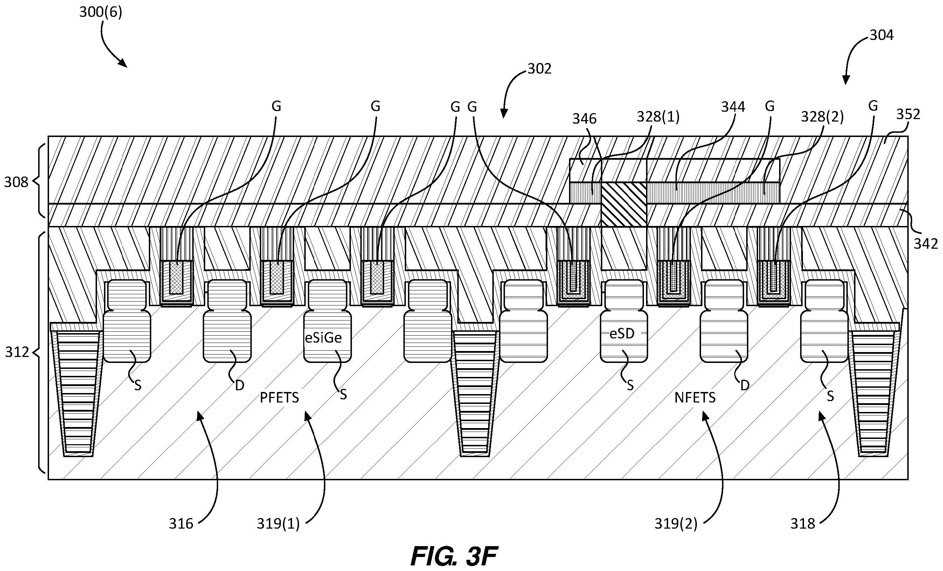

Next, as shown in process stage 300(6) in Figure 3F, another insulating layer 352, which may be an oxide layer, is disposed over the remaining first insulating layer 342, metal resistor 306, and second insulating layer 342 to prepare contacts to be formed in MOL layer 308. In subsequent processing steps, to continue with fabrication of MOL shielded gate 304, a first contact is formed with metal resistor 306 in MOL layer 308 and is in contact with first contact area 328 (block 210 in Figure 2). At least one interconnect layer is formed above MOL layer 308 (block 212 in Figure 2). A first interconnect is formed in the at least one interconnect layer electrically coupled to the first contact, to electrically couple first interconnect to first contact area 328 of metal resistor (block 214 in Figure 2). Vias may be formed in interconnect layer above MOL layer 308 to electrically couple contacts in MOL layer 308 and in active semiconductor layer 312.

MOL shielded gates in integrated circuits (ICs), and according to any of the examples disclosed herein, may be provided in or integrated into any processor-based device. Examples, without limitation, include set top boxes, entertainment units, navigation devices, communications devices, fixed location data units, mobile location data units, mobile phones, cellular phones, smart phones, tablets, phablets, computers, portable computers, desktop computers, personal digital assistants (PDAs), monitors, computer monitors, televisions, tuners, radios, satellite radios, music players, digital music players, portable music players, digital video players, video players, digital video disc (DVD) players, portable digital video players, and automobiles.

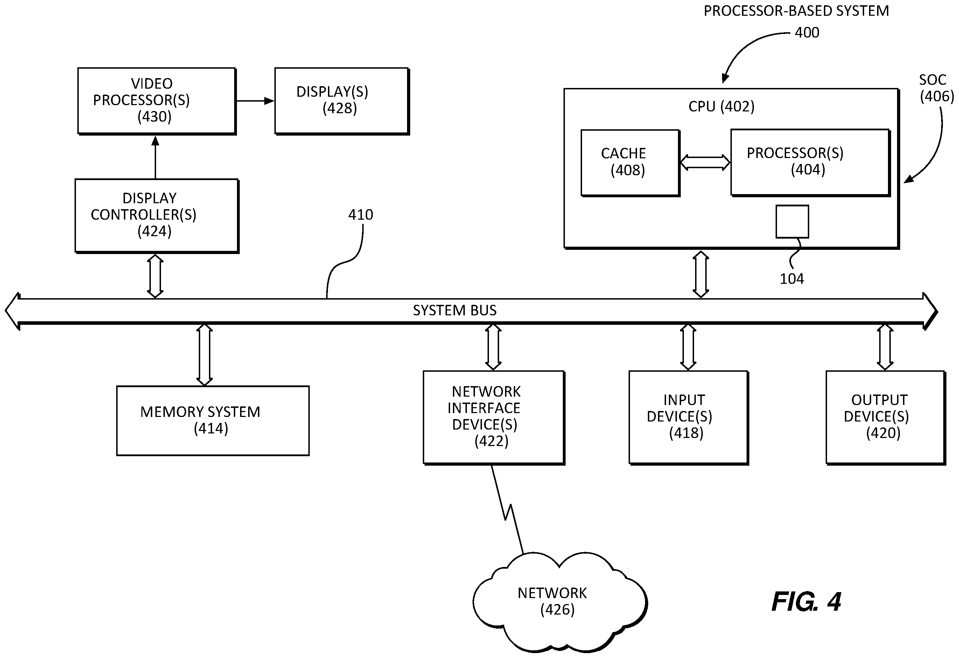

In this regard, Figure 4 illustrates an example of a processor-based system 400 that includes a CPU 402 that includes one or more processors 404. The processor-based system 400 may be provided as a system-on-a-chip (SoC) 406. The CPU 402 may have a cache memory 408 coupled to the processor(s) 404 for rapid access to temporarily stored data. The CPU 402 may include the MOL shielded gate 104. The CPU 402 is coupled to a system bus 410 and can be coupled to other devices included in the processor-based system 400. The processor(s) 404 in the CPU 402 can communicate with these other devices by exchanging address, control, and data information over the system bus 410. Although not illustrated in Figure 4, multiple system buses 410 could be provided, wherein each system bus 410 constitutes a different fabric. For example, the CPU 402 can communicate bus transaction requests to a memory in a memory system 414 as an example of a slave device.

Other devices can be connected to the system bus 410. As illustrated in Figure 4, these devices can include the memory system 414, one or more input devices 418, one or more output devices 420, one or more network interface devices 422, and one or more display controllers 424, as examples. The input device(s) 418 can include any type of input device, including but not limited to input keys, switches, voice processors, etc. The output device(s) 420 can include any type of output device, including but not limited to audio, video, other visual indicators, etc. The network interface device(s) 422 can be any devices configured to allow exchange of data to and from a network 426. The network 426 can be any type of network, including but not limited to a wired or wireless network, a private or public network, a local area network (LAN), a wireless local area network (WLAN), a wide area network (WAN), a BLUETOOTH^{™} network, and the Internet. The network interface device(s) 422 can be configured to support any type of communications protocol desired.

The CPU 402 may also be configured to access the display controller(s) 424 over the system bus 410 to control information sent to one or more displays 428. The display(s) 428 can include any type of display, including but not limited to a cathode ray tube (CRT), a liquid crystal display (LCD), a plasma display, etc. The display controller(s) 424 sends information to the display(s) 428 to be displayed via one or more video processors 430, which process the information to be displayed into a format suitable for the display(s) 428.

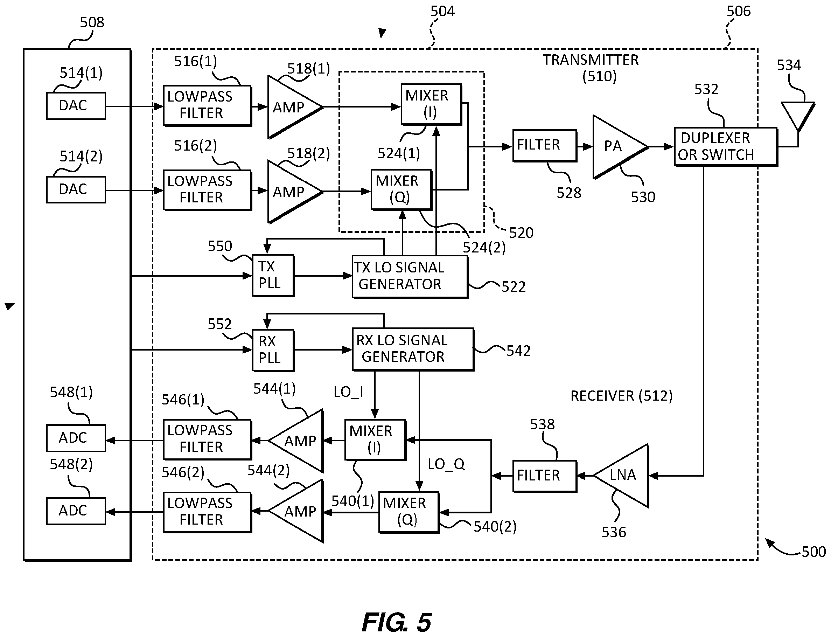

Figure 5 illustrates an example of a wireless communications device 500 which can include RF components in which a MOL shielded gate 104 is used in an integrated circuit (IC) 506 to reduce gate to drain parasitic capacitance. In this regard, the wireless communications device 500 is provided in IC 506. The wireless communications device 500 may include or be provided in any of the above referenced devices such as a smart phone. As shown in Figure 5, the wireless communications device 500 includes a transceiver 504 and a data processor 508. The IC 506 and/or the data processor 508 includes the MOL shielded gate 104 to reduce gate to drain parasitic capacitance. The data processor 508 may include a memory (not shown) to store data and program codes. The transceiver 504 includes a transmitter 510 and a receiver 512 that support bi-directional communication. In general, the wireless communications device 500 may include any number of transmitters and/or receivers for any number of communication systems and frequency bands. All or a portion of the transceiver 504 may be implemented on one or more analog ICs, RF ICs (RFICs), mixed-signal ICs, etc.

A transmitter or a receiver may be implemented with a super-heterodyne architecture or a direct-conversion architecture. In the super-heterodyne architecture, a signal is frequency-converted between RF and baseband in multiple stages, e.g., from RF to an intermediate frequency (IF) in one stage, and then from IF to baseband in another stage for a receiver. In the direct-conversion architecture, a signal is frequency converted between RF and baseband in one stage. The super-heterodyne and direct-conversion architectures may use different circuit blocks and/or have different requirements. In the wireless communications device 500 in Figure 5, the transmitter 510 and the receiver 512 are implemented with the direct-conversion architecture.

In the transmit path, the data processor 508 processes data to be transmitted and provides I and Q analog output signals to the transmitter 510. In the exemplary wireless communications device 500, the data processor 508 includes digital-to-analog-converters (DACs) 514(1) and 514(2) for converting digital signals generated by the data processor 508 into the I and Q analog output signals, e.g., I and Q output currents, for further processing.

Within the transmitter 510, lowpass filters 516(1), 516(2) filter the I and Q analog output signals, respectively, to remove undesired images caused by the prior digital-to-analog conversion. Amplifiers (AMP) 518(1), 518(2) amplify the signals from the lowpass filters 516(1), 516(2), respectively, and provide I and Q baseband signals. An upconverter 520 upconverts the I and Q baseband signals with I and Q transmit (TX) local oscillator (LO) signals through mixers 524(1), 524(2) from a TX LO signal generator 522 to provide an upconverted signal 526. A filter 528 filters the upconverted signal to remove undesired images caused by the frequency upconversion as well as noise in a receive frequency band. A power amplifier (PA) 530 amplifies the upconverted signal from the filter 528 to obtain the desired output power level and provides a transmit RF signal. The transmit RF signal is routed through a duplexer or switch 532 and transmitted via an antenna 534.

In the receive path, the antenna 534 receives signals transmitted by base stations and provides a received RF signal, which is routed through the duplexer or switch 532 and provided to a low noise amplifier (LNA) 536. The duplexer or switch 532 is designed to operate with a specific RX-to-TX duplexer frequency separation, such that RX signals are isolated from TX signals. The received RF signal is amplified by the LNA 536 and filtered by a filter 538 to obtain a desired RF input signal. Downconversion mixers 540(1), 540(2) mix the output of the filter 538 with I and Q receive (RX) LO signals (i.e., LO_I and LO_Q) from an RX LO signal generator 542 to generate I and Q baseband signals. The I and Q baseband signals are amplified by amplifiers (AMP) 544(1), 544(2) and further filtered by lowpass filters 546(1), 546(2) to obtain I and Q analog input signals, which are provided to the data processor 508. In this example, the data processor 508 includes analog-to-digital-converters (ADCs) 548(1), 548(2) for converting the analog input signals into digital signals to be further processed by the data processor 508.

In the wireless communications device 500 in Figure 5, the TX LO signal generator 522 generates the I and Q TX LO signals used for frequency upconversion, while the RX LO signal generator 542 generates the I and Q RX LO signals used for frequency downconversion. Each LO signal is a periodic signal with a particular fundamental frequency. A transmit (TX) phase-locked loop (PLL) circuit 550 receives timing information from the data processor 508 and generates a control signal used to adjust the frequency and/or phase of the TX LO signals from the TX LO signal generator 522. Similarly, a receive (RX) phase-locked loop (PLL) circuit 552 receives timing information from the data processor 508 and generates a control signal used to adjust the frequency and/or phase of the RX LO signals from the RX LO signal generator 542.

Those of skill in the art will further appreciate that the various illustrative logical blocks, modules, circuits, and algorithms described in connection with the aspects disclosed herein may be implemented as electronic hardware, instructions stored in memory or in another computer-readable medium and executed by a processor or other processing device, or combinations of both. The devices described herein may be employed in any circuit, hardware component, integrated circuit (IC), or IC chip, as examples. Memory disclosed herein may be any type and size of memory and may be configured to store any type of information desired. To clearly illustrate this interchangeability, various illustrative components, blocks, modules, circuits, and steps have been described above generally in terms of their functionality.

It is also noted that the operational steps described in any of the exemplary aspects herein are described to provide examples and discussion. The operations described may be performed in numerous different sequences other than the illustrated sequences. Furthermore, operations described in a single operational step may actually be performed in a number of different steps. Additionally, one or more operational steps discussed in the exemplary aspects may be combined. It is to be understood that the operational steps illustrated in the flow chart diagrams may be subject to numerous different modifications as will be readily apparent to one of skill in the art.

## Claims

1. A middle-of-line, MOL, shielded gate (104) for an integrated circuit, IC, (102) comprising:
an active semiconductor layer (112) comprising a first semiconductor device (120);
a metal resistor (106) comprising a metal material disposed in an MOL layer (108), the MOL layer disposed above the active semiconductor layer;
wherein the first semiconductor device comprises a transistor comprising a source (S), a drain (D), and a gate (124) interdisposed between the source and the drain;
wherein the metal resistor is disposed over the gate of the transistor such that gate to drain parasitic capacitance in the transistor is reduced; and
wherein the MOL layer (108) has a thickness of approximately eighteen, 18, nanometers, nm, or less and wherein a ratio of the thickness of the MOL layer to a thickness of the active semiconductor layer (112) is approximately 0.26 or less.

2. The MOL shielded gate for the IC of claim 1, further comprising:
a contact (126(1)) disposed above the metal resistor in the MOL layer, the contact electrically coupled to a contact area (128) of the metal resistor; and
an interconnect (136(1)) disposed in an interconnect layer (132) above the MOL layer, the interconnect layer electrically coupled to the contact to electrically couple the interconnect to the contact area of the metal resistor.

3. The MOL shielded gate for the IC of claim 1, wherein the metal resistor is located in the MOL layer within approximately seven, 7, nanometers, nm, of the first semiconductor device.

4. The MOL shielded gate for the IC of claim 2, wherein the interconnect is comprised of a metal line.

5. The MOL shielded gate for the IC of claim 2, further comprising:
a vertical interconnect access, via, (130(1)) disposed in the interconnect layer, the via in contact with the contact area of the metal resistor and the interconnect, to electrically couple the contact area to the interconnect.

6. The MOL shielded gate for the IC of claim 1, wherein the metal material comprises tungsten.

7. The MOL shielded gate for the IC of claim 1, wherein a size of the metal resistor is approximately W/L of 0.21 µm / 0.21 µm.

8. The MOL shielded gate for the IC of claim 1, wherein the resistance of the metal resistor is at least 400 ohms per W/L ratio of 1.0 µm / 1.0 µm.

9. The MOL shielded gate for the IC of claim 1 integrated into a system-on-a-chip, SoC (406).

10. The MOL shielded gate for the IC of claim 1, integrated into a device selected from the group consisting of: a set top box; an entertainment unit; a navigation device; a communications device; a fixed location data unit; a mobile location data unit; a mobile phone; a cellular phone; a smart phone; a tablet; a phablet; a computer; a portable computer; a desktop computer; a personal digital assistant, PDA; a monitor; a computer monitor; a television; a tuner; a radio; a satellite radio; a music player; a digital music player; a portable music player; a digital video player; a video player; a digital video disc, DVD, player; a portable digital video player; and an automobile.

11. A method (200) of fabricating a shielded gate in a semiconductor die for an integrated circuit, IC, comprising:
forming (202) a substrate;
forming (204) an active semiconductor layer above the substrate;
forming (206) at least one semiconductor device in the active semiconductor layer; and
forming (208) a middle-of-line, MOL, layer above the active semiconductor layer, comprising: forming a metal resistor having a resistance and comprising a metal material in the MOL layer, the metal resistor comprising a contact area;
wherein the forming the at least one semiconductor device in the active semiconductor layer comprises forming a transistor comprising a source, a drain, and a gate interdisposed between the source and the drain;
wherein the forming the metal resistor comprises forming the metal resistor comprising the metal material in the MOL layer over the gate of the transistor to reduce gate to drain parasitic capacitance; and
wherein forming the MOL layer comprises forming the MOL layer with a thickness of approximately eighteen, 18, nanometers, nm, or less and a ratio of the thickness of the MOL layer to a thickness of the active semiconductor layer (112) of approximately 0.26 or less.

12. The method of claim 11, further comprising:
forming (210) a contact above the metal resistor in the MOL layer and in contact with the contact area of the metal resistor;
forming (212) at least one interconnect layer above the MOL layer; and
forming (214) an interconnect in the at least one interconnect layer electrically coupled to the contact, to electrically couple the interconnect to the contact area of the metal resistor.

13. The method of claim 12, further comprising:
forming a vertical interconnect access, via, in the interconnect, the via in contact with the contact area of the metal resistor and the interconnect, to electrically couple the contact area to the interconnect.

## Patentansprüche

1. Ein abgeschirmtes Middle-of-Line (MOL)-Gatter (104) für einen integrierten Schaltkreis (Integrated Circuit bzw. IC) (102), aufweisend:
eine aktive Halbleiterschicht (112), die ein erstes Halbleiterbauelement (120) aufweist,
einen Metallwiderstand (106), der ein in einer MOL-Schicht (108) angeordnetes Metallmaterial aufweist, wobei die MOL-Schicht über der aktiven Halbleiterschicht angeordnet ist,
wobei das erste Halbleiterbauelement einen Transistor aufweist, der eine Source (S), einen Drain (D) und ein zwischen der Source und dem Drain angeordnetes Gate (124) aufweist,
wobei der Metallwiderstand derart über dem Gate des Transistors angeordnet ist, dass eine parasitäre Gate-zu-Drain-Kapazität in dem Transistor reduziert ist, und
wobei die MOL-Schicht (108) eine Dicke von ungefähr achtzehn (18) Nanometer (nm) oder weniger aufweist und wobei das Verhältnis der Dicke der MOL-Schicht zu der Dicke der aktiven Halbleiterschicht (112) ungefähr 0,26 oder weniger beträgt.

2. Abgeschirmtes MOL-Gatter für einen IC nach Anspruch 1, das weiterhin aufweist:
einen Kontakt (126(1)), der über dem Metallwiderstand in der MOL-Schicht angeordnet ist, wobei der Kontakt elektrisch mit einer Kontaktfläche (128) des Metallwiderstands gekoppelt ist, und
eine Verbindung (136(1)), die in einer Verbindungsschicht (132) über der MOL-Schicht angeordnet ist, wobei die Verbindungsschicht elektrisch mit dem Kontakt gekoppelt ist, um die Verbindung elektrisch mit der Kontaktfläche des Metallwiderstands zu koppeln.

3. Abgeschirmtes MOL-Gatter für einen IC nach Anspruch 1, wobei der Metallwiderstand in der MOL-Schicht innerhalb von ungefähr sieben (7) Nanometer (nm) des ersten Halbleiterbauelements angeordnet ist.

4. Abgeschirmtes MOL-Gatter für einen IC nach Anspruch 2, wobei die Verbindung aus einer Metallleitung besteht.

5. Abgeschirmtes MOL-Gatter für einen IC nach Anspruch 2, das weiterhin aufweist:
einen vertikalen Verbindungszugangsdurchgang (130(1)), der in der Verbindungsschicht angeordnet ist, wobei der Durchgang in Kontakt mit der Kontaktfläche des Metallwiderstands und der Verbindung ist, um die Kontaktfläche elektrisch mit der Verbindung zu koppeln.

6. Abgeschirmtes MOL-Gatter für einen IC nach Anspruch 1, wobei das Metallmaterial Wolfram umfasst.

7. Abgeschirmtes MOL-Gatter für einen IC nach Anspruch 1, wobei die Größe des Metallwiderstands eine Breite und Länge von ungefähr 0,21 µm / 0,21 µm aufweist.

8. Abgeschirmtes MOL-Gatter für einen IC nach Anspruch 1, wobei der Widerstand des Metallwiderstands wenigstens 400 Ohm pro Breite/Länge-Verhältnis von 1,0 µm / 1,0 µm aufweist.

9. Abgeschirmtes MOL-Gatter für einen IC nach Anspruch 1, das in einem System-on-a-Chip (SoC) (406) integriert ist.

10. Abgeschirmtes MOL-Gatter für einen IC nach Anspruch 1, das in einem Gerät integriert ist, das aus der Gruppe ausgewählt ist, die umfasst: eine Set-Top-Box, eine Unterhaltungseinheit, ein Navigationsgerät, ein Kommunikationsgerät, eine fix positionierte Dateneinheit, eine mobile Dateneinheit, ein Schnurlostelefon, ein Mobiltelefon, ein Smartphone, ein Tablet, ein Phablet, einen Computer, einen tragbaren Computer, einen Desktop-Computer, einen PDA (Personal Digital Assistant), einen Bildschirm, einen Computerbildschirm, ein Fernsehgerät, einen Tuner, ein Radio, ein Satellitenradio, ein Musikwiedergabegerät, ein digitales Musikwiedergabegerät, ein tragbares Musikwiedergabegerät, ein digitales Videowiedergabegerät, ein Videowiedergabegerät, ein DVD (Digital Video Disc)-Wiedergabegerät, ein tragbares digitales Videowiedergabegerät und ein Automobil.

11. Ein Verfahren (200) zum Herstellen eines abgeschirmten Gatters in einem Halbleiter-Die für eine integrierte Schaltung (Integrated Circuit bzw. IC), aufweisend:
Ausbilden (202) eines Substrats,
Ausbilden (204) einer aktiven Halbleiterschicht über dem Substrat,
Ausbilden (206) wenigstens eines Halbleiterbauelements in der aktiven Halbleiterschicht, und
Ausbilden (208) einer Middle-of-Line (MOL)-Schicht über der aktiven Halbleiterschicht, aufweisend:
Ausbilden eines Metallwiderstands, der einen Widerstand aufweist und ein Metallmaterial in der MOL-Schicht enthält, wobei der Metallwiderstand eine Kontaktfläche aufweist,
wobei das Ausbilden des wenigstens einen Halbleiterbauelements in der aktiven Halbleiterschicht das Ausbilden eines Transistors mit einer Source, einem Drain und einem zwischen der Source und dem Drain angeordneten Gate aufweist,
wobei das Ausbilden des Metallwiderstands das Ausbilden des Metallwiderstands mit dem Metallmaterial in der MOL-Schicht über dem Gate des Transistors für eine Reduktion der parasitären Gate-zu-Drain-Kapazität aufweist, und
wobei das Ausbilden der MOL-Schicht das Ausbilden der MOL-Schicht mit einer Dicke von ungefähr achtzehn (18) Nanometer (nm) oder weniger und einem Verhältnis der Dicke der MOL-Schicht zu der Dicke der aktiven Halbleiterschicht (112) von ungefähr 0,26 oder weniger aufweist.

12. Verfahren nach Anspruch 11, das weiterhin aufweist:
Ausbilden (210) eines Kontakts über dem Metallwiderstand in der MOL-Schicht und in einem Kontakt mit der Kontaktfläche des Metallwiderstands,
Ausbilden (212) wenigstens einer Verbindungsschicht über der MOL-Schicht, und
Ausbilden (214) einer Verbindung in der wenigstens einen elektrisch mit dem Kontakt gekoppelten Verbindungsschicht für ein elektrisches Koppeln der Verbindung mit der Kontaktfläche des Metallwiderstands.

13. Verfahren nach Anspruch 12, das weiterhin aufweist:
Ausbilden eines vertikalen Verbindungszugangsdurchgangs in der Verbindung, wobei der Durchgang in Kontakt mit der Kontaktfläche des Metallwiderstands und mit der Verbindung ist, um die Kontaktfläche elektrisch mit der Verbindung zu koppeln.

## Revendications

1. Grille blindée (104) de milieu de ligne, MOL, pour un circuit intégré, IC, (102) comprenant :
une couche semi-conductrice active (112) comprenant un premier dispositif semi-conducteur (120) ;
une résistance métallique (106) comprenant un matériau métallique disposé dans une couche MOL (108), la couche MOL étant disposée au-dessus de la couche semi-conductrice active ;
dans laquelle le premier dispositif semi-conducteur comprend un transistor comprenant une source (S), un drain (D) et une grille (124) interposée entre la source et le drain ;
dans laquelle la résistance métallique est disposée sur la grille du transistor de telle sorte que la capacité parasite grille-drain dans le transistor soit réduite ; et
dans laquelle la couche MOL (108) a une épaisseur d'environ dix-huit, 18, nanomètres, nm, ou moins et dans laquelle un rapport de l'épaisseur de la couche MOL à une épaisseur de la couche semi-conductrice active (112) est d'environ 0,26 ou moins.

2. Grille blindée MOL pour le circuit intégré selon la revendication 1, comprenant en outre :
un contact (126(1)) disposé au-dessus de la résistance métallique dans la couche MOL, le contact étant couplé électriquement à une zone de contact (128) de la résistance métallique ; et
une interconnexion (136(1)) disposée dans une couche d'interconnexion (132) au-dessus de la couche MOL, la couche d'interconnexion étant couplée électriquement au contact pour coupler électriquement l'interconnexion à la zone de contact de la résistance métallique.

3. Grille blindée MOL pour le circuit intégré selon la revendication 1, dans laquelle la résistance métallique est située dans la couche MOL dans la limite d'environ sept, 7, nanomètres, nm, du premier dispositif semi-conducteur.

4. Grille blindée MOL pour le circuit intégré selon la revendication 2, dans laquelle l'interconnexion est constituée d'une ligne métallique.

5. Grille blindée MOL pour le circuit intégré selon la revendication 2, comprenant en outre :
un accès d'interconnexion vertical, via, (130(1)) disposé dans la couche d'interconnexion, le via étant en contact avec la zone de contact de la résistance métallique et l'interconnexion, pour coupler électriquement la zone de contact à l'interconnexion.

6. Grille blindée MOL pour le circuit intégré selon la revendication 1, dans laquelle le matériau métallique comprend du tungstène.

7. Grille blindée MOL pour le circuit intégré selon la revendication 1, dans laquelle la taille de la résistance métallique est d'environ W/L de 0,21 µm / 0,21 µm.

8. Grille blindée MOL pour le circuit intégré selon la revendication 1, dans laquelle la résistance de la résistance métallique est d'au moins 400 ohms par rapport W/L de 1,0 µm / 1,0 µm.

9. Grille blindée MOL pour le circuit intégré selon la revendication 1 intégrée dans un système sur puce, SoC (406).

10. Grille blindée MOL pour le circuit intégré selon la revendication 1, intégrée dans un dispositif choisi dans le groupe constitué par : un décodeur; une unité de divertissement ; un dispositif de navigation ; un dispositif de communication ; une unité de données de localisation fixe ; une unité de données de localisation mobile ; un téléphone mobile ; un téléphone cellulaire ; un téléphone intelligent ; une tablette ; une phablette ; un ordinateur ; un ordinateur portable ; un ordinateur de bureau ; un assistant numérique personnel, PDA ; un moniteur ; un écran d'ordinateur ; une télévision ; un syntoniseur ; une radio ; une radio par satellite ; un lecteur de musique ; un lecteur de musique numérique ; un lecteur de musique portable ; un lecteur vidéo numérique ; un lecteur vidéo ; un lecteur de disque vidéo numérique, DVD, un lecteur vidéo numérique portable ; et une automobile.

11. Procédé (200) de fabrication d'une grille blindée dans une puce semi-conductrice pour un circuit intégré, IC, comprenant :
la formation (202) d'un substrat ;
la formation (204) d'une couche semi-conductrice active au-dessus du substrat ;
la formation (206) d'au moins un dispositif semi-conducteur dans la couche semi-conductrice active ; et
la formation (208) d'une couche de milieu de ligne, MOL, au-dessus de la couche semi-conductrice active, comprenant :
la formation d'une résistance métallique ayant une résistance et comprenant un matériau métallique dans la couche MOL, la résistance métallique comprenant une zone de contact ;
dans lequel la formation du ou des dispositifs semi-conducteurs dans la couche semi-conductrice active comprend la formation d'un transistor comprenant une source, un drain et une grille interposée entre la source et le drain ;
dans lequel la formation de la résistance métallique comprend la formation de la résistance métallique comprenant le matériau métallique dans la couche MOL sur la grille du transistor pour réduire la capacité parasite grille-drain ; et
dans lequel la formation de la couche MOL comprend la formation de la couche MOL avec une épaisseur d'environ dix-huit, 18, nanomètres, nm, ou moins et un rapport de l'épaisseur de la couche MOL à une épaisseur de la couche semi-conductrice active (112) d'environ 0,26 ou moins.

12. Procédé selon la revendication 11, comprenant en outre :
la formation (210) d'un contact au-dessus de la résistance métallique dans la couche MOL et en contact avec la zone de contact de la résistance métallique ;
la formation (212) d'au moins une couche d'interconnexion au-dessus de la couche MOL ; et
la formation (214) d'une interconnexion dans la ou les couches d'interconnexion couplées électriquement au contact, pour coupler électriquement l'interconnexion à la zone de contact de la résistance métallique.

13. Procédé selon la revendication 12, comprenant en outre :
la formation d'un accès d'interconnexion vertical, via, dans l'interconnexion, le via étant en contact avec la zone de contact de la résistance métallique et l'interconnexion, pour coupler électriquement la zone de contact à l'interconnexion.
